# EUROPEAN PATENT APPLICATION

(11) **EP 2 913 928 A1**
(43) Date of publication of application: **02.09.2015**
(21) Application number: 14305286.8
(22) Date of filing: 27.02.2014
(51) Int. Cl.: H03M 1/12, H03M 1/36

(54) **Circuitry and method for converting a multi-level signal into at least one binary signal**

(71) Applicant: ALCATEL LUCENT, 92100 Boulogne-Billancourt (FR)
(72) Inventor: Sinsky, Jeffrey, Holmdel, NJ New Jersey 07733-1661 (US)
(74) Representative: D'Halleweyn, Nele Veerle Trees Gertrudis

(57) **Abstract**

A circuitry for converting a multi-level signal in particular a duobinary signal, said multi-level signal having a period T, comprising: comparing and splitting circuitry configured for comparing a value of said multi-level signal with (n-1) different reference values, and having N sets of (n-1) output terminals for outputting N sets of (n-1) output signals indicating whether the value of the multi-level signal is below or above the (n-1) reference values, N sets of (n-1) sample-and-hold circuits having an input and an output and being configured for operating at a clock period N*T, wherein each output terminal is connected to the input of a sample-and-hold circuit; logical circuitry connected to the outputs of the N sets of (n-1) sample-and-hold circuits for generating at least one binary signal having a period N*T.

## Description

### Field of Invention

The field of the invention relates to circuitry, in particular receiver circuitry, for converting a multi-level signal, in particular a duobinary signal, into at least one binary signal, as well as to methods for converting a multi-level signal into at least one binary signal.

### Background

As electrical and optical transmission systems operate at higher and higher data rates, approaching values greater than 100 Gb/s, it becomes increasingly difficult to design circuitry such as receiver hardware that can operate at such high data rates.

Current state-of-the-art duobinary receivers collect and process data serially at the data rate of the received duobinary signal. At data rates approaching more than 100 Gb/s, it is very difficult to design all of the analog and digital components to have an appropriate operating bandwidth.

### Summary

The object of embodiments of the invention is to solve this problem and to provide circuitry which can deal with multi-level signals, in particular duobinary signals, having a high frequency.

According to a first aspect of the invention there is provided a circuitry for converting a multi-level signal, in particular a duobinary signal, into at least one binary signal, said multi-level signal having a period T and comprising n signal levels, n being equal to or greater than 3. For duobinary signals n equals 3. The circuitry comprises comparing and splitting circuitry, sample-and-hold circuitry and logic circuitry. The comparing and splitting circuitry is configured for comparing a value of said multi-level signal with (n-1) different reference values, and has N sets of (n-1) output terminals for outputting N sets of (n-1) output signals, each set of (n-1) output signals indicating whether the value of the multi-level signal is below or above the (n-1) reference values, wherein N is greater than or equal to 2. The sample-and-hold circuitry comprises N sets of (n-1) sample-and-hold circuits having an input and an output and being configured for operating at a clock period N*T. Each set of said N sets is arranged for sampling-and-holding at moments in time which are shifted in time with respect to another set of said N sets. Each output terminal of a set of said N sets of (n-1) output terminals is connected to the input of a sample-and-hold circuit of a corresponding set of said N sets of (n-1) sample-and-hold circuits. The logical circuitry is connected to the outputs of the N sets of (n-1) sample-and-hold circuits for generating at least one binary signal having a period N*T, using the signals on the outputs of the N sets of (n-1) sample-and-hold circuits.

Embodiments of the invention are based *inter alia* on the insight that by cleverly designing the circuitry the bandwidth requirements of many of the circuitry components can be eased. In reality, often the multi-level signal is a result of multiplexing data at a transmitter side, whereby the inventors realized that at the receiving side processing of the data with lower bandwidth components would be advantageous. In embodiments of the invention the sample-and-hold circuitry and the logic circuitry can operate at a lower frequency thanks to the provision of the splitting and comparing circuitry

In a preferred embodiment n equals 3 and the multi-level signal is a duobinary signal. This will allow for the design of very high speed duobinary systems using lesser bandwidth components for the sample-and-hold circuitry and the logic circuitry than would currently be required. This enables duobinary technology to be used where it otherwise might not be possible because of unavailable or very costly hardware components.

According to a preferred embodiment each set of said N sets of two sample-and-hold circuits is arranged for sampling-and-holding at moments in time which are shifted over the time period T with respect to another set of said N sets. In that way the multilevel signal can be accurately sampled. According to a preferred embodiment the logic circuitry is configured for generating N binary signals.

According to an exemplary embodiment the comparing and splitting circuitry comprises: a plurality of splitters for splitting the duobinary signal in N sets of two multilevel signals; N sets of two comparators; each comparator having an input connected for receiving a duobinary signal of said N sets of two multilevel signals, and an output; each comparator of a set of said N sets being configured with a different reference value of said two reference values; wherein the output of each comparator is connected to a sample-and-hold circuit of a corresponding set of said N sets of two sample-and-hold circuits.

According to a preferred embodiment the logical circuitry comprises N XOR circuits. Typically a first XOR circuit of said N XOR circuits has a first input connected to the output of a first sample-and-hold circuit of a first set of said N sets of two sample-and-hold circuits and a second input connected to a second different sample-and-hold circuit of said first set; and a second XOR circuit of said N XOR circuits has a first input connected to the output of a first sample-and-hold circuit of a second set of said N sets of two sample-and-hold circuits and a second input connected to a second different sample-and-hold circuit of said second set.

According to a preferred embodiment the circuitry further comprises receiver circuitry for receiving a signal and an amplifier for amplifying the received signal, said amplified received signal forming the duobinary signal. The receiver circuitry may be configured for receiving an optical signal and for converting said optical signal into the duobinary signal.

In a preferred embodiment the N sets of (n-1) sample-and-hold circuits are N sets of (n-1) flip-flop circuits.

In an exemplary embodiment the comparing and splitting circuitry and the N sets of (n-1) sample-and-hold circuits are implemented as circuitry comprising at least one splitter, at least two comparators and at least two demultiplexers.

According to another aspect of the invention, there is provided a method for converting a multi-level signal into at least one binary signal, said multi-level signal having a period T and comprising n signal levels, n being equal to or greater than 3. The method comprises:
- comparing a value of said multi-level signal with (n-1) different reference values, and outputting N sets of (n-1) output signals, each set of (n-1) output signals indicating whether the value of the multi-level signal is below or above the (n-1) reference values, wherein N is greater than or equal to 2;
- operating N sets of (n-1) sample-and-hold circuits at a clock period N*T, each set of said N sets sampling-and-holding at moments in time which are shifted in time with respect to another set of said N sets; wherein each set of (n-1) output signals of said N sets of (n-1) output signals is sent to a corresponding set of said N sets of (n-1) sample-and-hold circuits;
- generating at least one binary signal having a period N*T, using the signals output by the N sets of (n-1) sample-and-hold circuits.

According to a preferred embodiment n equals 3, and said multi-level signal is a duobinary signal.

According to a preferred embodiment each set of said N sets of two sample-and-hold circuits is sampling-and-holding at moments in time which are shifted over the time period T with respect to another set of said N sets.

According to a preferred embodiment the method further comprises receiving a signal and amplifying the received signal, said amplified received signal forming the duobinary signal. According to a possible embodiment the method may comprise receiving an optical signal and converting the received optical signal into the duobinary signal.

According to yet another aspect of the invention, there is provided a circuitry for performing the method of any one of the embodiments disclosed above.

### Brief description of the figures

The accompanying drawings are used to illustrate presently preferred non-limiting exemplary embodiments of devices of the present invention. The above and other advantages of the features and objects of the invention will become more apparent and the invention will be better understood from the following detailed description when read in conjunction with the accompanying drawings, in which:
Figure 1 is a schematic diagram of an exemplary embodiment of circuitry of the invention;
Figure 2 is a schematic diagram of an exemplary embodiment of circuitry of the invention where n=3 and N=2;
Figure 3 is a schematic diagram of another exemplary embodiment of circuitry of the invention where n=3 and N=2;
Figure 4 is a schematic diagram of an exemplary embodiment of circuitry of the invention where n=3 and N=4;
Figure 5 is a schematic diagram of another exemplary embodiment of circuitry of the invention where n=3 and N=4;
Figure 6 is a flow chart illustrating an embodiment of the method of the invention; and
Figure 7 is a plot that shows the power spectral density of duobinary versus binary in function of the normalized frequency.

### Description of embodiments

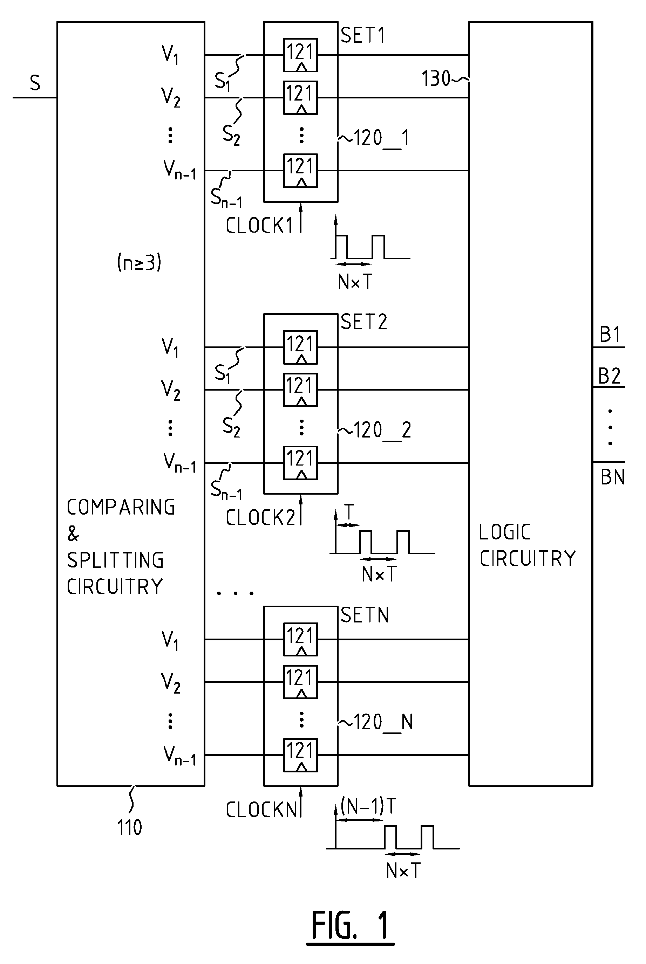

Figure 1 illustrates a general exemplary embodiment of circuitry for converting a multi-level signal into at least one binary signal. It is assumed that the multi-level signal has a period T and that it comprises n signal levels, n being equal to or greater than 3. The circuitry comprises comparing and splitting circuitry 110, N sets of (n-1) sample-and-hold circuits 120_1, 120_2, ..., 120_N, and logic circuitry 130. N is greater than or equal to 2. In the illustrated embodiment of figure 1, it appears as if N is greater than 2, but the skilled person understands that there may be only two sets 120_1, 120_2 of sample-and-hold circuits if N = 2.

The comparing and splitting circuitry 110 is configured for comparing a value of said multi-level signal with (n-1) different reference values V₁, V₂, ... Vₙ₋₁, and has N sets of (n-1) output terminals for outputting N sets of (n-1) output signals S1, S2, ... Sn-1. Each output signal S1, S2, ... Sn-1 indicates whether the value of the multi-level signal S is below or above a respective reference value V₁, V₂, ... Vₙ₋₁, respectively. I.e. S1 indicates whether S is below or above V₁, S2 indicates whether S is below or above V₂, etc. In a typical embodiment the comparing and splitting circuitry 110 comprises a plurality of splitters and a plurality of comparators.

The N sets 120_1, 120_2, ... 120_N of (n-1) sample-and-hold circuits 121 are configured for operating at a clock period N*T. Each set of said N sets is arranged for sampling-and-holding at moments in time which are shifted over a time period T with respect to another set of said N sets. In the illustrated embodiment set 120_2 is provided with a clock which is shifted over a period T with respect to the clock of set 120_1, and set 120_N is provided with a clock which is shifted over a period (N-1)*T with respect to the clock of set 120_1. Although not illustrated the skilled person understands that there may be provided additional circuitry for generating said clock signals CLOCK 1, CLOCK 2, ... CLOCK N. Each output terminal of the comparing and splitting circuitry 110 is connected to the input of a sample-and-hold circuit of a corresponding set 120_1, 120_2, ... 120_N.

The logical circuitry 130 is connected to the outputs of the N*(n-1) sample-and-hold circuits 121 for generating at least one binary signal using the signals S1, S2, ... Sn-1 on the outputs of the N sets of (n-1) sample-and-hold circuits 121. Typically the logical circuitry 130 is configured to generate N binary signals B1, B2, ... BN using e.g. XOR circuits. In that way the data in the multi-level signal S with frequency 1/T is converted into N binary signals B1, B2, ..., BN with a frequency 1/(N*T).

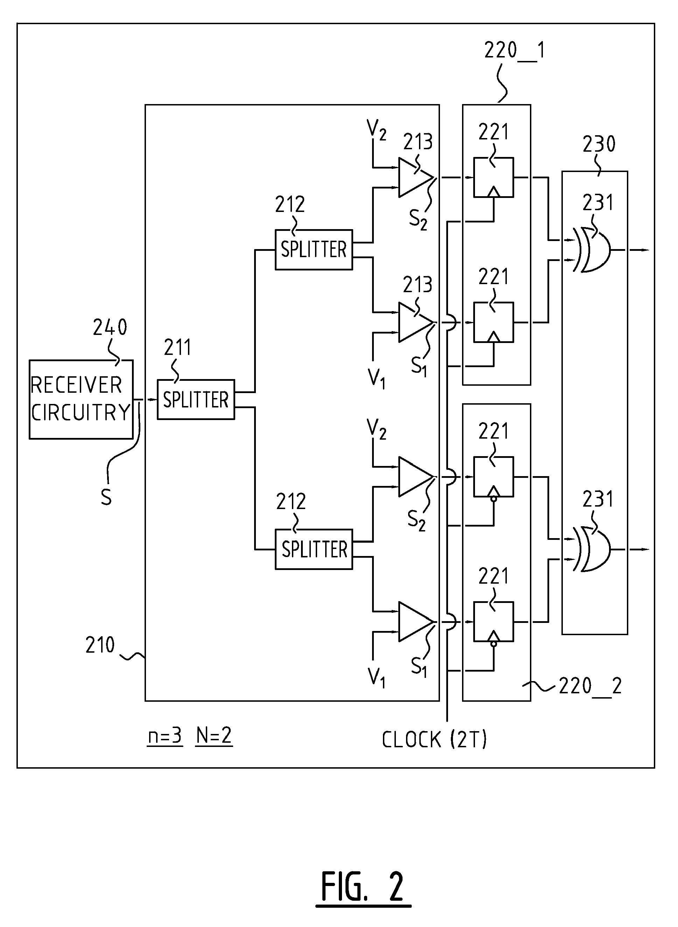

Figure 2 illustrates an exemplary embodiment for which n = 3 and N = 2, i.e. the multi-level signal is a duobinary signal. The circuitry comprises comparing and splitting circuitry 210, two sets 220_1, 220_2 of each two flip-flop circuits 221, and logic circuitry 230.

The comparing and splitting circuitry 210 comprises a plurality of first splitters 211, 212 for splitting the duobinary signal S in two sets of two multilevel signals; and two sets of two comparators 213. Each comparator 213 has an input connected for receiving a duobinary signal of said two sets of two duobinary signals, and an output. A first comparator 213 of a set is configured for comparing the signal S with a first reference value V₁, and a second comparator 213 of a set is configured for comparing the signal S with a second reference value V₂. The output of each comparator 213 is connected to a flip-flop circuit of a corresponding set 220_1, 220_2. The first set 220_1 of flip-flop circuits is arranged for sampling and holding in accordance with a rising edge of clock signal CLK, and the second set of flip-flop circuits 220_2 is arranged for sampling and holding in accordance with a falling edge of the clock signal CLK.

The logical circuitry 230 comprises two XOR circuits 231. A first XOR circuit 231 has a first input connected to the output of a first flip-flop circuit 221 of a first set 220_1 and a second input connected to a second different flip-flop circuit 221 of said first set 220_1. A second XOR circuit 231 has a first input connected to the output of a first flip-flop circuit 221 of a second set 220_2 and a second input connected to a second different flip-flop circuit 221 of said second set 220_2. The logical circuitry 230 is configured to generate two binary signals B1, B2. In that way the data in the duobinary signal S with frequency 1/T is converted into two binary signals B1, B2 with a frequency 1/(2*T).

Further there is provided receiver circuitry 240. The receiver circuitry may comprise an amplifier for amplifying the received signal, said amplified received signal forming the duobinary signal S. In another embodiment the receiver circuitry 240 may be configured for receiving an optical signal and for converting said optical signal into the duobinary signal S.

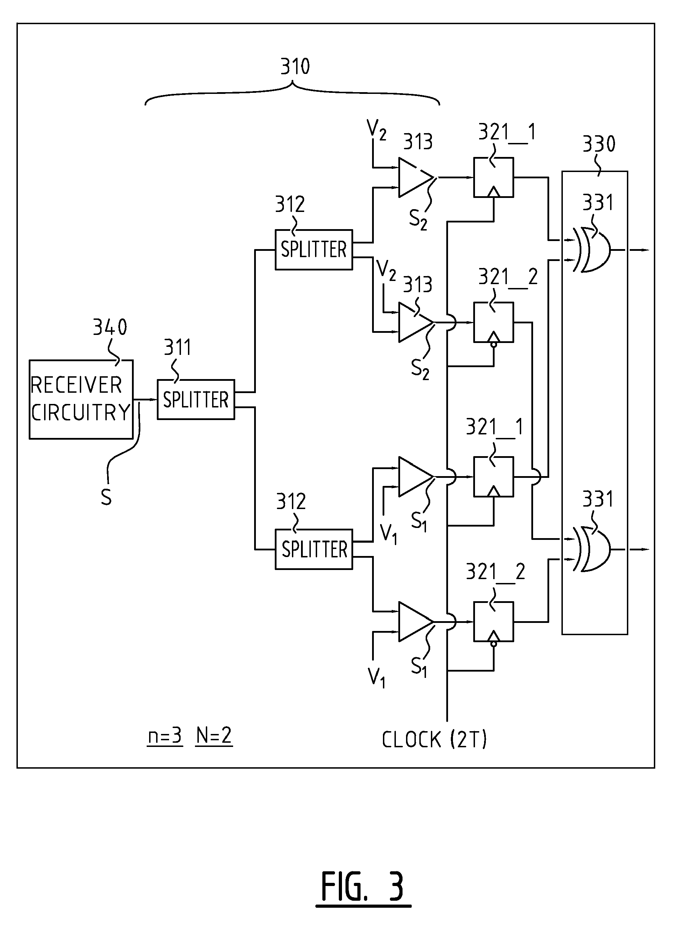

In the case of an optical duobinary signal, typically a slight augmentation of the typical duobinary transmission signal format is required. In many modem optical duobinary transmission systems, duobinary signaling is accomplished by allowing the two "1" states of the data to be equal amplitude but opposite phase optical signals. A zero is coded as no signal. As such, a photodetector can provide full wave rectification of a received optical signal regenerating the original NRZ waveform without further signal processing. The problem with the typical optical approach in prior art systems is that by virtue of carrying out the full wave rectification directly, the signal available in the electrical domain is already at X Gb/s, thus requiring a photodetector such as a photodiode and demultiplexer at X Gb/s. The solution to this problem is to sum a coherent optical carrier to the optical duobinary signal either at the transmitter or at the receiver. By doing so, the optical signal is translated into a true three-level optical waveform. The purpose in doing this is to avoid the full wave rectification process at the photodiode. By doing this, the narrower power spectral density of the duobinary signal is preserved when it is translated from the optical domain to the electrical domain. The waveform emerging from the photodiode will now be duobinary, not NRZ. This lower bandwidth electrical duobinary signal can then be processed as described above in the electrical case. This architecture now only requires an X/2 Gb/S photodiode and demultiplexer. Figure 3 illustrates another exemplary embodiment for which n = 3 and N = 2, i.e. the multi-level signal is a duobinary signal. The circuitry comprises comparing and splitting circuitry 310, two sets of each two flip-flop circuits 321_1, 321_2, and logic circuitry 330 with two XOR circuits 331. The comparing and splitting circuitry 310 comprises a plurality of splitters 311, 312 for splitting the duobinary signal S in two sets of two multilevel signals; and two sets of two comparators 313. The circuitry is largely similar to the circuitry of figure 2 with this difference that the comparators 313 are connected in a different way to splitters 312.

For the case where n = 3 and N = 2 (e.g. the embodiments of figure 2 and 3), and assuming a data rate of X Gb/s, embodiments provide a scheme for detection and demultiplexing X/2 Gb/s NRZ data B 1, B2 that only requires hardware with a bandwidth that supports X/2 Gb/s NRZ data. This is accomplished by noting that the inherent power spectral density of duobinary data S has a null at X/2 GHz for a data rate of X Gb/s, and that instead of converting the X Gb/s duobinary data to X Gb/s NRZ data and then demultiplexing, the process can be done all at once at the lower data rate, X/2 Gb/s. In modem networking applications, X is becoming so high (e.g. 100 Gb/s or more) that electrical components are not commercially available for such systems. Since most high speed links of this type are typically demultiplexed, in embodiments of the invention, there is nothing lost by only providing the demultiplexed outputs B1, B2 in lieu of the initial high-speed (X Gb/s) stream.

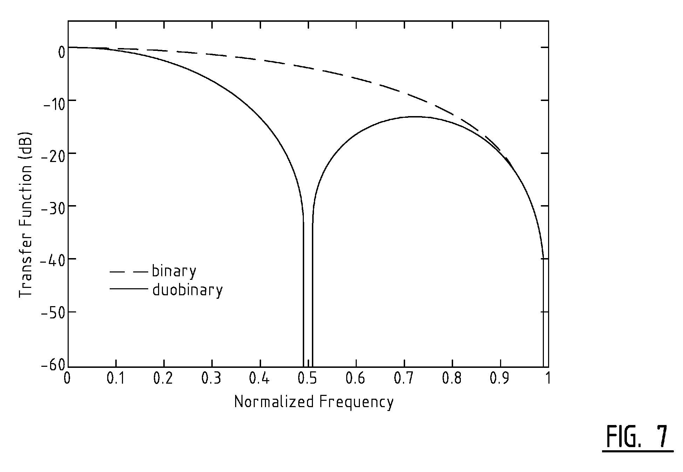

Figure 7 is a plot that shows the power spectral density of duobinary versus binary. Embodiments of the invention are based on the following insight. For duobinary the first spectral null is about half that of binary. The inventors have realized that the spectral content above this null is not really needed to maintain the integrity of the signal. This is the reason why the initial splitting circuitry and flip-flops can operate at half the bandwidth. Or, stated differently, X Gb/s duobinary only needs X/2 GHz of bandwidth. This is also the reason why the two data streams can be correctly separated, even though there appears to be transitions at every bit boundary. The transition rules that exist with the duobinary data will prevent the higher frequency components from occurring in the signal.

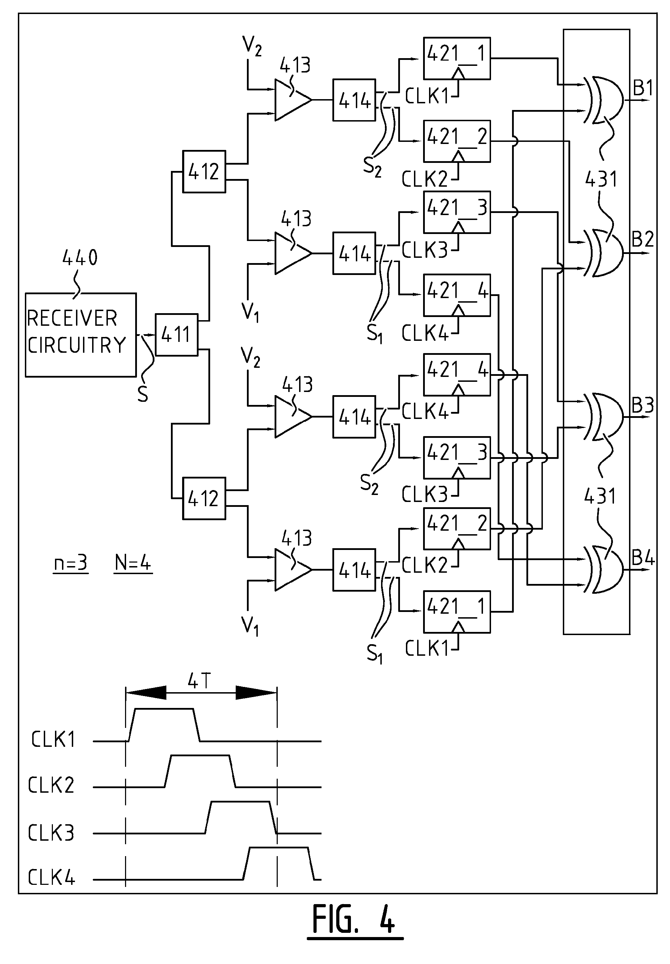

Figure 4 illustrates an exemplary embodiment for which n = 3 and N = 4, i.e. the multi-level signal is a duobinary signal and the frequency is reduced by a factor 4. The circuitry comprises comparing and splitting circuitry 410, four sets of each two flip-flop circuits 421_1, 421_2, 421_3, 421_4, and logic circuitry 430 with four XOR circuits 431. The comparing and splitting circuitry 410 comprises a plurality of first splitters 411, 412 for splitting the duobinary signal S in two sets of two duobinary signals; two sets of two comparators 413, and four second splitters 414 for splitting the signals output by the comparators 413 so that four sets of two output signals S1, S2 are obtained. Each set of each two flip-flop circuits 421_1, 421_2, 421_3, 421_4 is provided with a respective clock CLK1, CLK2, CLK3, CLK4. As in the embodiment of figure 1 the clock signals CLK1, CLK2, CLK3, CLK4 are preferably shifted over a period T with respect to each other. The circuitry is largely similar to the circuitry of figure 2 with this difference that the additional splitters 414 are provided and that eight instead of four flip-flop circuits are used so that binary signals with a frequency (1/4T) can be obtained. In this embodiment, if the signal S is assumed to be an X Gb/s signal, than the logic circuitry 430 can be built with X/4 Gb/s XOR circuits 431. Although the D-flipflops 421_1, 421_2, 421_3, 421_4 are clocked less frequently compared to the case where N = 2 (figures 2 and 3), the clock "pulse" may still have to be narrow, and it may not be possible to have X/4 Gb/s bandwidth D-flip-flops. However these flip-flop can have a lower bandwidth compared to prior art solutions, e.g. X/2 Gb/S.

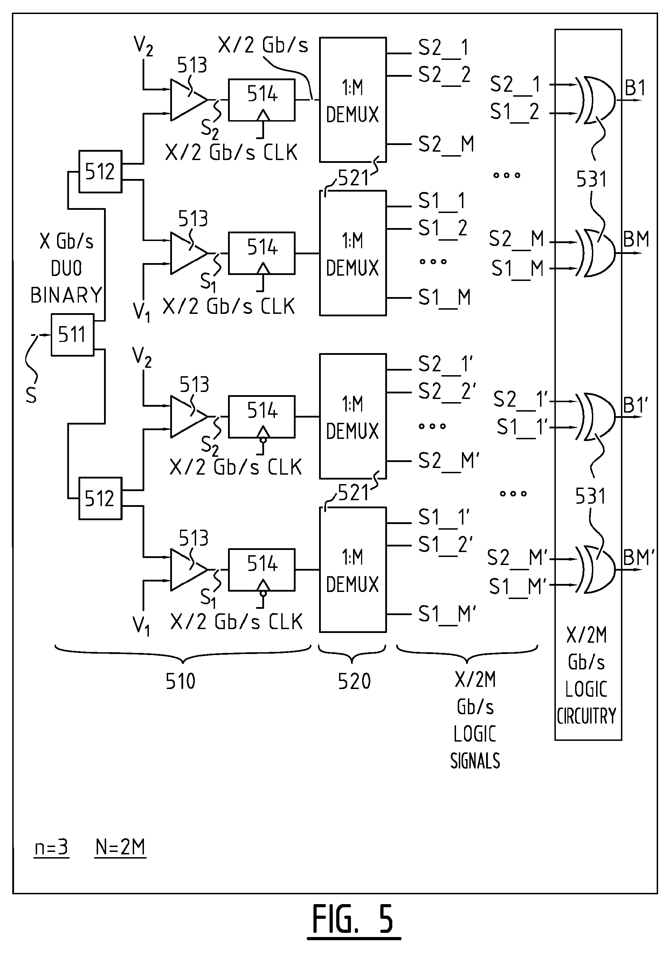

Figure 5 illustrates an exemplary embodiment for which n = 3 and N = 2M, i.e. the multi-level signal is a duobinary signal and the frequency is reduced by a factor 2M. The circuitry comprises comparing and splitting circuitry 510, 2M sets of each two sample-and-hold circuits (as part of the four 1:M demultiplexers 521, see further), and logic circuitry 430 with 2M XOR circuits 431. The comparing and splitting circuitry 510 comprises a plurality of first splitters 511, 512 for splitting the duobinary signal S in two sets of two duobinary signals; two sets of two comparators 513, four flip-flops 514 and the first stage components of the 1:M demultiplexers 521. The logic in the demultiplexers 521, such as clocks, flip-flops, etc, has varying clock rates, namely faster towards the input and slower towards the output. In the last stage before the output, each demultiplexer 521 comprises M sample-and-hold circuits, such that 2M sets of two output signals S1_1, S2_1; S1_1', S2_1' ... S1_M, S2_M; S1_M', S2_M' are obtained.
In that way there would be less flip-flops that require higher bandwidth: there are only four flip-flops 514 that require X/2 Gb/s and the flip-flops used in the 1:M demultiplexers will require less bandwidth than X/2 Gb/s.
The skilled person will understand that yet other variants of the embodiments of figures 2-5 fall within the scope of the invention. E.g. in the embodiment of figure 5 flip-flops 514 may be omitted and the demultiplexers 521 could be I:N (i.e. 1:2M) demultiplexers.

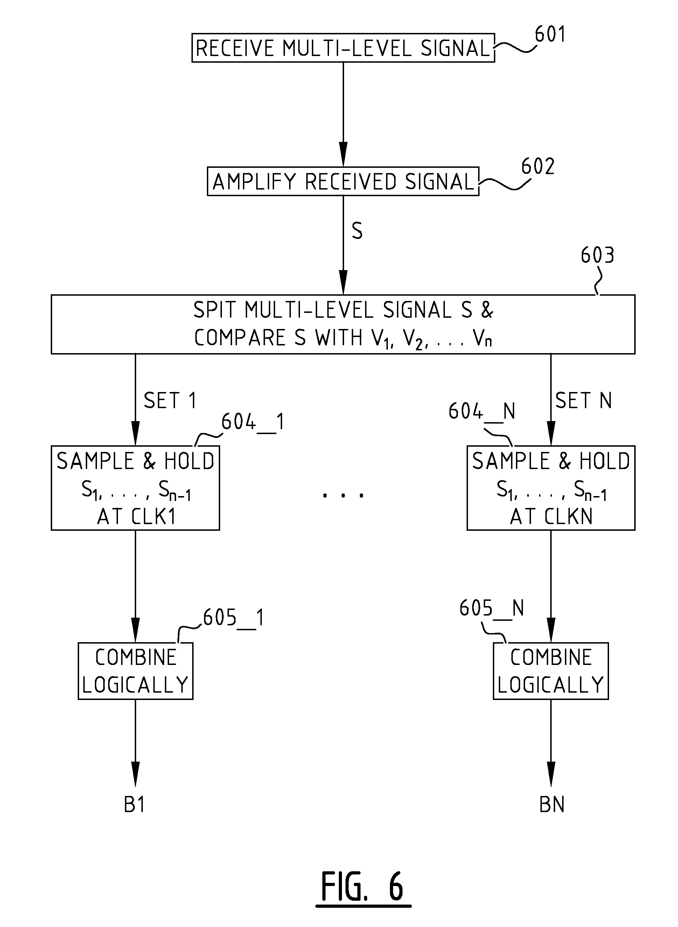

Figure 6 illustrates a flow chart of an embodiment of the method of the invention for converting a multi-level signal into at least one binary signal, said multi-level signal having a period T and comprising n signal levels, n being equal to or greater than 3. In a first step 601 a multilevel signal is received. This step may comprise receiving an optical signal and converting the optical signal in a multilevel signal. In a second step 602 the received or converted signal is amplified to obtain the multi-level signal S. In a third step 603 a value of said multi-level signal S is compared with (n-1) different reference values V₁, V₂, ... Vₙ, and N sets of (n-1) output signals S1, ... Sn-1 are output. Each set of (n-1) output signals indicate whether the value of the multi-level signal S is below or above the (n-1) reference values, wherein N is greater than or equal to 2.

In steps 604_1 to 604_N each set of (n-1) output signals S1, .. Sn-1 (SET1, ... SETN) is sent to a corresponding set of (n-1) sample-and-hold circuits; wherein each set of said N sets of sample-and-hold circuits operates at a clock period N*T and samples-and-holds at moments in time which are shifted in time with respect to another set of said N sets. In the illustrated embodiment the first set uses a clock CLK1 which may be similar to CLOCK 1 is figure 1, and set N may use a clock CLKN which may be similar to CLOCK N is figure 1. In steps 605_1 to 605_N N binary signals B1, ... BN having a period N*T are generated, using the signals output by the N sets of (n-1) sample-and-hold circuits.

Embodiments of the invention allow for the design of very high speed duobinary systems using lesser bandwidth components than would currently be required. This enables duobinary technology to be used where it otherwise might not be possible because of unavailable or very costly hardware components.

The functions of the various elements shown in the figures, including any functional blocks labelled as e.g. "circuitry" or "modules", may be provided through the use of dedicated hardware as well as hardware capable of executing software in association with appropriate software.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Whilst the principles of the invention have been set out above in connection with specific embodiments, it is to be understood that this description is merely made by way of example and not as a limitation of the scope of protection which is determined by the appended claims.

## Claims

1. A circuitry for converting a multi-level signal into at least one binary signal, said multi-level signal having a period T and comprising n signal levels, n being equal to or greater than 3, comprising:
- comparing and splitting circuitry configured for comparing a value of said multi-level signal with (n-1) different reference values, and having N sets of (n-1) output terminals for outputting N sets of (n-1) output signals, each set of (n-1) output signals indicating whether the value of the multi-level signal is below or above the (n-1) reference values, wherein N is greater than or equal to 2;
- N sets of (n-1) sample-and-hold circuits having an input and an output and being configured for operating at a clock period N*T, each set of said N sets being arranged for sampling-and-holding at moments in time which are shifted in time with respect to another set of said N sets;
wherein each output terminal of a set of said N sets of (n-1) output terminals is connected to the input of a sample-and-hold circuit of a corresponding set of said N sets of (n-1) sample-and-hold circuits;
- logical circuitry connected to the outputs of the N sets of (n-1) sample-and-hold circuits for generating at least one binary signal having a period N*T, using the signals on the outputs of the N sets of (n-1) sample-and-hold circuits.

2. The circuitry of claim 1, wherein n equals 3 and said multi-level signal is a duobinary signal.

3. The circuitry of claim 2, wherein each set of said N sets of two sample-and-hold circuits is arranged for sampling-and-holding at moments in time which are shifted over the time period T with respect to another set of said N sets.

4. The circuitry of claim 2 or 3, wherein said comparing and splitting circuitry comprises:
- a plurality of splitters for splitting the duobinary signal in N sets of two multilevel signals;
- N sets of two comparators; each comparator having an input connected for receiving a duobinary signal of said N sets of two duobinary signals, and an output; each comparator of a set of said N sets being configured with a different reference value of said two reference values;
wherein the output of each comparator is connected to a sample-and-hold circuit of a corresponding set of said N sets of two sample-and-hold circuits.

5. The circuitry of any one of the claims 2-4, wherein said logical circuitry comprises N XOR circuits.

6. The circuitry of claim 5, wherein a first XOR circuit of said N XOR circuits has a first input connected to the output of a first sample-and-hold circuit of a first set of said N sets of two sample-and-hold circuits and a second input connected to a second different sample-and-hold circuit of said first set; and wherein a second XOR circuit of said N XOR circuits has a first input connected to the output of a first sample-and-hold circuit of a second set of said N sets of two sample-and-hold circuits and a second input connected to a second different sample-and-hold circuit of said second set.

7. The circuitry of any one of the claims 1-6, further comprising receiver circuitry and an amplifier for amplifying the received signal, said amplified received signal forming the duobinary signal.

8. The circuitry of claim 7, wherein the receiver circuitry is configured for receiving an optical signal and for converting said optical signal into the duobinary signal.

9. The circuitry of any one of the claims 2-8, wherein the N sets of two sample-and-hold circuits comprise N sets of two flip-flop circuits.

10. The circuitry of any one of the claims 2-9, wherein the comparing and splitting circuitry and the N sets of (n-1) sample-and-hold circuits are implemented as circuitry comprising at least one splitter, at least two comparators and at least two demultiplexers.

11. A method for converting a multi-level signal into at least one binary signal, said multi-level signal having a period T and comprising n signal levels, n being equal to or greater than 3, comprising:
- comparing a value of said multi-level signal with (n-1) different reference values, and outputting N sets of (n-1) output signals, each set of (n-1) output signals indicating whether the value of the multi-level signal is below or above the (n-1) reference values, wherein N is greater than or equal to 2;
- operating N sets of (n-1) sample-and-hold circuits at a clock period N*T, each set of said N sets sampling-and-holding at moments in time which are shifted in time with respect to another set of said N sets; wherein each set of (n-1) output signals of said N sets of (n-1) output signals is sent to a corresponding set of said N sets of (n-1) sample-and-hold circuits;
- generating at least one binary signal having a period N*T, using the signals output by the N sets of (n-1) sample-and-hold circuits.

12. The method of claim 11, wherein n equals 3 and said multi-level signal is a duobinary signal.

13. The method of claim 12, wherein each set of said N sets of two sample-and-hold circuits is sampling-and-holding at moments in time which are shifted over the time period T with respect to another set of said N sets.

14. The method of claim 11 or 12, further comprising receiving an optical signal and converting the received optical signal into the duobinary signal.

15. Circuitry for performing the method of any one of the claims 11-14.
